# EUROPEAN PATENT APPLICATION

(11) **EP 3 168 888 A1**
(43) Date of publication of application: **17.05.2017**
(21) Application number: 15818414.3
(22) Date of filing: 10.07.2015
(51) Int. Cl.: H01L 51/50, H05B 33/10

(54) **CHARGE-TRANSPORTING VARNISH**

(30) Priority: 11.07.2014 JP 2014142995
(71) Applicant: Nissan Chemical Industries, Ltd., Chiyoda-ku Tokyo 101-0054 (JP)
(72) Inventor: NAKAIE Naoki, Funabashi-shi Chiba 274-0052 (JP)
(74) Representative: Bailey, Sam Rogerson
(86) International application number: PCT/JP2015/069821
(87) International publication number: WO 2016/006673

(57) **Abstract**

A charge-transporting varnish according to the present invention includes a charge-transporting substance, a dopant substance, and an organic solvent, wherein the charge-transporting substance contains at least one selected from N,N'-di(l-naphthyl)benzidine, N,N'-di(2-naphthyl)benzidine, and N-(1-naphthyl)-N'-(2-naphthyl)benzidine. The charge-transporting varnish allows formation of a charge-transporting thin film with which an organic EL element excellent in durability can be achieved when the charge-transporting thin film is applied to a hole injection layer.

## Description

### TECHNICAL FIELD

The present invention relates to a charge-transporting varnish and more particularly, to a charge-transporting varnish containing N,N'-dinaphthylbenzidine.

### BACKGROUND ART

Organic electroluminescent (EL) elements have been expected to be put into practical use in the field of display and illumination, for which materials and element structures have been diversely developed so as to achieve low voltage drive, high luminance, long life and the like.

The organic EL element makes use of a plurality of functional thin films, among which a hole injection layer is included. The hole injection layer plays a role in donating and accepting charges between an anode and a hole transporting layer or a light emission layer and bears an important function for achieving the low voltage drive and high luminance of an organic EL element.

The method of forming this hole injection layer can be broadly classified into a dry process, typical of which is a vacuum deposition process, and a wet process, typical of which is a spin coating process. When comparing these processes with each other, the wet process is able to efficiently produce a thin film having a larger area and a better flatness, so that the wet process has been frequently employed particularly in the field of display.

Under such circumstances as stated above, the present inventors have developed a number of charge-transporting varnishes containing aniline derivatives as a charge-transporting substance (see Patent Documents 1 to 4). Especially, it has been found that when a thin film, which is obtained from a charge-transporting varnish containing given types of aryldiamine compound and electron-accepting dopant, is used as a hole injection layer, there can be obtained an organic EL element excellent in luminance characteristics and the like (see Patent Document 4).

However, with respect to the wet process materials for the hole injection layer, improvements therefor have been invariably demanded. The organic EL element provided with the thin film of Patent Document 4 has a room for improvement in durability.

### PRIOR ART DOCUMENTS

### PATENT DOCUMENTS

Patent Document 1: WO 2006/025342
Patent Document 2: WO 2008/032616
Patent Document 3: WO 2010/058777
Patent Document 4: WO 2013/042623

### SUMMARY OF THE INVENTION

### PROBLEMS TO BE SOLVED BY THE INVENTION

The present invention has been made under such circumstances as described above and has for its object the provision of a charge-transporting varnish that is able to yield a charge-transporting thin film capable of realizing an organic EL element excellent in durability when applied to a hole injection layer.

### MEANS FOR SOLVING THE PROBLEMS

The present inventors have intensive studies so as to achieve the above object and, as a result, found that when a thin film formed from a charge-transporting varnish prepared by using, as a charge-transporting substance, N,N'-dinaphthylbenzidine particularly selected among various aryldiamine compounds is applied to a hole injection layer of an organic EL element, an organic EL element having excellent durability can be obtained, thus arriving at completion of the present invention.

Specifically, the present invention provides the following:
1. A charge-transporting varnish includes a charge-transporting substance, a dopant substance, and an organic solvent, wherein the charge-transporting substance contains at least one selected from N,N'-di(l-naphthyl)benzidine, N,N'-di(2-naphthyl)benzidine, and N-(1-naphthyl)-N'-(2-naphthyl)benzidine;
2. The charge-transporting varnish of 1, wherein the dopant substance contains an arylsulfonic acid compound as its essential component;
3. The charge-transporting varnish of 1 or 2, wherein the charge-transporting substance contains N,N'-di(l-naphthyl)benzidine;
4. The charge-transporting varnish of 2 or 3, wherein the dopant substance further includes a heteropoly acid;
5. A charge-transporting thin film prepared by use of the charge-transporting varnish of any one of 1 to 4;
6. An organic electroluminescent element includes the charge-transporting thin film of 5;
7. The electroluminescent element of 6, wherein the charge-transporting thin film serves as a hole injection layer;
8. A method for fabricating a charge-transporting thin film includes coating the charge-transporting varnish of any one of 1 to 4 onto a substrate and evaporating the solvent; and
9. A method for improving luminance durability of an organic electroluminescent element having an anode and a cathode, and a plurality of functional layers interposed between the anode and the cathode and including a light emission layer, a hole injection layer, and a hole transporting layer, the method includes using at least one selected from N,N'-di(l-naphthyl)benzidine, N,N'-di(2-naphthyl)benzidine, and N-(1-naphthyl)-N'-(2-naphthyl)benzidine as a charge-transporting substance for the hole injection layer.

### ADVANTAGEOUS EFFECTS OF THE INVENTION

The thin film prepared from the charge-transporting varnish of the present invention shows high charge transportability and can thus be conveniently used as a thin film for electronic devices including an organic EL element. Especially, when this thin film is applied to a hole injection layer of an organic EL element, there can be obtained an organic EL element that is excellent in luminance durability.

Also, the charge-transporting varnish of the present invention is able to reproducibly produce a thin film excellent in charge transportability in the case of using a variety of wet processes capable of large-area film formation, such as a spin coating process and a slit coating process. Hence, the charge-transporting varnish can be addressed for recent development in the field of organic EL elements.

### EMBODIMENT FOR CARRYING OUT THE INVENTION

The present invention is now described in more detail.

The charge-transporting varnish of the present invention includes a charge-transporting substance and a dopant substance. The charge-transporting substance contains at least one selected from N,N'-di(l-naphthyl)benzidine, N,N'-di(2-naphthyl)benzidine, and N-(1-naphthyl)-N'-(2-naphthyl)benzidine.

Although at least one of the above three compounds should be contained as the charge-transporting substance, the use of N,N'-di(1-naphthyl)benzidine and N,N'-di(2-naphthyl)benzidine is preferred. More preferably, N,N'-di(1-naphthyl)benzidine is used.

It will be noted that other types of known charge-transporting substances may be used in combination with N,N'-dinaphthylbenzidine as a charge-transporting substance of the present invention. In this connection, however, the N,N'-dinaphthylbenzidine should be a main component (over 50% by weight) of the charge-transporting substance from the standpoint of improvement in durability of the resultant organic EL element. Preferably, the content of the N,N'-dinaphthylbenzidine is at least 70% by weight, more preferably at least 90% by weight, and much more preferably 100% by weight, of the total charge-transporting substance.

For the reason described above, according to a preferred embodiment of the present invention, at least one of N,N'-di(1-naphthyl)benzidine and N,N'-di(2-naphthyl)benzidine is preferably present in the total charge-transporting substance in an amount of at least 70% by weight, more preferably at least 90% by weight, and much more preferably 100% by weight. In a more preferred embodiment, N,N'-di(1-naphthyl)benzidine is preferably present in the total charge-transporting substance in an amount of at least 70% by weight, more preferably at least 90% by weight, and much more preferably 100% by weight.

Further, the charge-transporting varnish of the present invention contains a dopant substance.

Specific examples of the dopant substance includes a heteropoly acid and an arylsulfonic acid compound. In view of improvement in luminance durability of an organic EL element provided with the thin film obtained from the varnish, the dopant substance should preferably contain an arylsulfonic acid compound as an essential component.

The arylsulfonic acid compound is not specifically limited and usable ones can be appropriately selected from hitherto known arylsulfonic acid compounds. For examples, the arylsulfonic acid compounds indicated in WO 2006/025342 and the arylsulfonic acid compounds indicated in WO 2009/096352 can be conveniently used.

Among them, the arylsulfonic acid compound represented by the formula (1) or (2) is preferred.

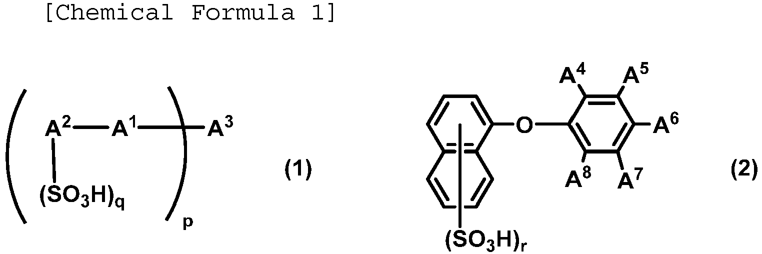

In the formula (1), A¹ represents O or S, of which O is preferred.

A² represents a naphthalene ring or an anthracene ring, of which the naphthalene ring is preferred.

A³ represents a divalent to tetravalent perfluorophenyl group and letter p is the number of bonds between A¹ and A³ and is an integer satisfying 2 ≤ p ≤ 4, preferably provided that A³ is a divalent perfluorophenyl group and letter p is 2.

Letter q is the number of the sulfonic acid groups bonded to A³ and is an integer satisfying 1 ≤ q ≤ 4 and is optimally 2.

In the formula (2), A⁴ to A⁸ independently represent a hydrogen, a halogen, a cyano, an alkyl group having 1 to 20 carbon atoms, a halogenated alkyl group having 1 to 20 carbon atoms, or a halogenated alkenyl group having 2 to 20 carbon atoms provided that at least three of A⁴ to A⁸ are a halogen.

Letter r is the number of the sulfonic acid groups bonded to the naphthalene ring and is an integer satisfying 1 ≤ r ≤ 4, which is preferably 2 to 4 and optimally 2.

The halogen includes fluorine, chlorine, bromine, and iodine, of which fluorine is preferred.

The alkyl group having 1 to 20 carbon atoms may have any of linear, branched, and cyclic structures and includes, for example, a linear or branched alkyl group having 1 to 20 carbon atoms such as methyl, ethyl, n-propyl, isopropyl, n-butyl, isobutyl, s-butyl, t-butyl, n-pentyl, n-hexyl, n-heptyl, n-octyl, n-nonyl, or n-decyl; and a cyclic alkyl group having 3 to 20 carbon atoms such as cyclopropyl, cyclobutyl, cyclopentyl, cyclohexyl, cycloheptyl, cyclooctyl, cyclononyl, cyclodecyl, bicyclobutyl, bicyclopentyl, bicyclohexyl, bicycloheptyl, bicyclooctyl, bicyclononyl, or bicyclodecyl.

The halogenated alkyl group having 1 to 20 carbon atoms includes those groups wherein at least one hydrogen atom of the above alkyl group having 1 to 20 carbon atoms is substituted with a halogen atom. Specific examples includes trifluoromethyl, 2,2,2-trifluoroethyl, 1,1,2,2,2-pentafluoroethyl, 3,3,3-trifluoropropyl, 2,2,3,3,3-pentafluoropropyl, 1,1,2,2,3,3,3-heptafluoropropyl, 4,4,4-trifluorobutyl, 3,3,4,4,4-pentafluorobutyl, 2,2,3,3,4,4,4-heptafluorobutyl, and 1,1,2,2,3,3,4,4,4-nonafluorobutyl.

For the halogenated alkenyl group having 2 to 20 carbon atoms, mention is made of those groups wherein at least one hydrogen atom of the alkenyl group having 2 to 20 carbon atoms, such as ethenyl, n-1-propenyl, n-2-propenyl, 1-methylethenyl, n-1-butenyl, n-2-butenyl, n-3-butenyl, 2-methyl-1-propenyl, 2-methyl-2-propenyl, 1-ethylethenyl, 1-methyl-1-propenyl, 1-methyl-2-propenyl, n-1-pentenyl, n-1-decenyl, or n-1-eicosenyl, is substituted with a halogen atom. Specific examples include perfluorovinyl, perfluoropropenyl (allyl), and perfluorobutenyl.

Among them, it is preferred that A⁴ to A⁸ are a hydrogen, a halogen, a cyano, an alkyl group having 1 to 10 carbon atoms, a halogenated alkyl group having 1 to 10 carbon atoms, or a halogenated alkenyl group having 2 to 10 carbon atoms provided that at least three of A⁴ to A⁸ are each fluorine. More preferably, A⁴ to A⁸ are a hydrogen, a fluorine, a cyano, an alkyl group having 1 to 5 carbon atoms, a fluorinated alkyl group having 1 to 5 carbon atoms, or a fluorinated alkenyl group having 2 to 5 carbon atoms provided that at least three of A⁴ to A⁸ are each fluorine. Much more preferably, A⁴ to A⁸ are a hydrogen, a fluorine, a cyano, a perfluoroalkyl group having 1 to 5 carbon atoms, a perfluoroalkenyl group having 1 to 5 carbon atoms provided that A⁴, A⁵, and A⁸ are each fluorine.

It will be noted that the perfluoroalkyl group means a group wherein all the hydrogen atoms of the alkyl group are substituted with a fluorine atom and that the perfluoroalkenyl group means a group wherein all the hydrogen atoms of the alkenyl group are substituted with a fluorine atom.

Specific example of a preferred arylsulfonic acid compound are those indicated below although not limited thereto.

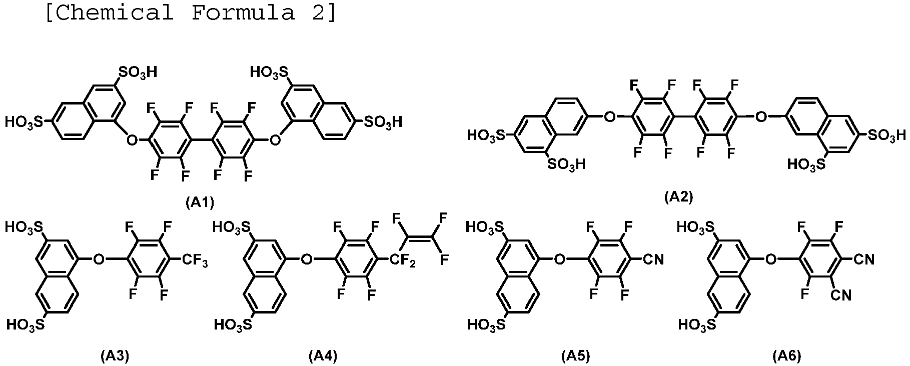

Where the arylsulfonic acid compound is used as a dopant substance, its amount is 0.05 to 15.0, preferably 0.10 to 10.0, more preferably 0.25 to 7.0, much more preferably 0.50 to 5.0, and most preferably 0.75 to 3.0, each by molar ratio to unit amount of a charge-transporting substance. Within this range, there can be reproducibly obtained a charge-transporting thin film that ensures high luminance and high durability when used in an organic EL element. More particularly, such a charge-transporting varnish satisfies that a ratio of an amount of an arylsulfonic acid compound (M_{A}) to an amount of a charge-transporting substance (M_{H}) is 0.05 ≤ M_{A}/M_{H} ≤ 15.0, preferably 0.10 ≤ M_{A}/M_{H} ≤ 10.0, more preferably 0.10 ≤ M_{A}/M_{H} ≤ 7.0, much more preferably 0.10 ≤ M_{A}/M_{H} ≤ 5.0, and most preferably 0.05 ≤ M_{A}/M_{H} ≤ 3.0.

The dopant substance used in the charge-transporting varnish of the present invention should preferably contain, as an essential component, an arylsulfonic acid compound as set out above. In order to improve charge transportability and the like, other type of dopant substance may be contained aside from the arylsulfonic acid compound.

Other type of dopant substance is not specifically limited so far as it is dissolved in at least one of solvents used in the varnish. Nevertheless, a heteropoly acid is preferred because of its good compatibility in the case of film thinning along with a charge-transporting substance and an arylsulfonic acid compound.

The heteropoly acid is one that has such a structure having a hetero atom located at the center of the molecule and indicated typically by a chemical structure of the Keggin type represented by the formula (B1) or the Dawson type represented by the formula (B2). The heteropoly acid is formed by condensation between an isopoly acid, which is an oxyacid of vanadium (V), molybdenum (Mo), or tungsten (W), and an oxyacid of a dissimilar element. The oxyacids of the dissimilar elements include those oxyacids mainly of silicon (Si), phosphorus (P), and arsenic (As).

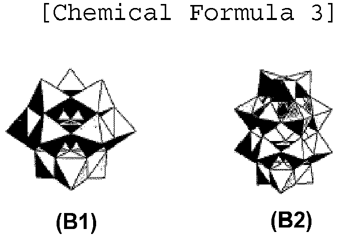

Specific examples of the heteropoly acid include phosphomolybdic acid, silicomolybdic acid, phosphotungstic acid, silicotungstic acid, and phosphotungstomolybdic acid. These may be used singly or in combination of at least two. It will be noted that the heteropoly acids used in the present invention are available as a commercial product and can be synthesized according to a known process.

Especially, where only one heteropoly acid is used along with an arylsulfonic acid compound, the heteropoly acid used is preferably phosphotungstic acid or phosphomolybdic acid, of which phosphotungstic acid is optimal. If at least two types of heteropoly acids are used along with an arylsulfonic acid compound, one of them should preferably be phosphotungstic acid or phosphomolybdic acid, of which phosphotungstic acid is more preferred.

It is to be noted that even if a heteropoly acid is one that is larger or smaller in the number of elements than the structure represented by the general formula in the quantitative analysis such as an elemental analysis, it can be used in the practice of the present invention provided that such a heteropoly acid is a commercial available one or is appropriately synthesized according to a known synthetic process.

More particularly, phosphotungstic acid is generally represented, for example, by the chemical formula H₃(PW₁₂O₄₀)·nH₂O and phosphomolybdic acid is represented by the chemical formula H₃(PMo₁₂O₄₀)·nH₂O. Those acids, which are larger or smaller in the number of P (phosphorus), O (oxygen), W (tungsten), or Mo (molybdenum) than the acid of the above formula in the quantitative analysis, can be used in the present invention provided that they are available as a commercial product or are appropriately synthetized according to a known synthetic process. In this case, the weight of a heteropoly acid defined in the present invention does not mean a weight of pure phosphotungstic acid (i.e. a content of phosphotungstic acid) in a synthesized or commercial product, but means a total weight of a heteropoly acid in an available form as a commercial product or in an isolable form in a known synthetic process and in the state of containing hydrated water and other impurities.

With the case using a heteropoly acid, its mass ratio is within a range of approximately 0.5 to 30.0, preferably approximately 1.0 to 20.0, more preferably approximately 2.0 to 15.0, much more preferably approximately 3.0 to 12.0, and most preferably approximately 4.0 to 11.0, all based on the unit weight of a charge-transporting substance. Within these ranges, there can be reproducibly obtained a charge-transporting thin film capable of giving high luminance when used in an organic EL element. More particularly, such a charge-transporting varnish is such that a ratio of the weight of a heteropoly acid (W_{D}) to the weight of a charge-transporting substance (W_{H}) satisfies 0.05 ≤ W_{D/}W_{H} ≤ 30.0, preferably 0.10 ≤ W_{D}/W_{H} ≤ 20.0, more preferably 0.10 ≤ W_{D}/W_{H} ≤ 15.0, much more preferably 0.10 ≤ W_{D}/W_{H} ≤ 12.0, and most preferably 0.10 ≤ W_{D}/W_{H} ≤ 11.0.

As an organic solvent used for preparing the charge-transporting varnish, there can be used high solubility solvents capable of well dissolving a charge-transporting substance and a dopant substance.

Examples of such high solubility solvent include organic solvents such as cyclohexane, N,N-dimethylformamide, N,N-dimethylacetamide, N-methylpyrrolidone, 1,3-dimethyl-2-imidazolidinone, and diethylene glycol monomethyl ether although not limited thereto. These solvents may be used singly or in admixture of at least two. The amount can be 5% to 100% by weight relative to the total of the solvents used in the varnish.

It will be noted that the charge-transporting substance and the dopant substance should preferably be completely dissolved or uniformly dispersed in the above solvent, and complete dissolution is more preferred.

Also, in the practice of the present invention, when at least one high-viscosity organic solvent, which has a viscosity of 10 to 200 mPa·s at 25°C, preferably 35 to 150 mPa·s and a boiling point of 50°C to 300°C at a normal pressure (atmospheric pressure), preferably 150°C to 250°C, is added to the varnish, it becomes easy to adjust the viscosity of the varnish. As a consequence, there can be prepared a varnish that is able to reproducibly provide a thin film having good flatness and is suited depending on the type of coating process to be used.

Examples of the high-viscosity organic solvent include cyclohexanol, ethylene glycol, ethylene glycol diglycidyl ether, 1,3-octylene glycol, diethylene glycol, dipropylene glycol, triethylene glycol, tripropylene glycol, 1,3-butanediol, 2,3-butanediol, 1,4-butanediol, propylene glycol, and hexylene glycol although not limited thereto. These solvents may be used singly or in admixture of at least two.

The addition ratio of the high-viscosity organic solvent to the whole solvent used in the varnish of the present invention is preferably within a range where no solid is precipitated, and the addition ratio is preferably at 5% to 90% by weight so far as no solid is precipitated.

Further, other types of solvents may be added at a ratio of 1% to 90% by weight, preferably 1% to 50% by weight, relative to the whole solvent used in the varnish for the purposes of improvement in wettability to a substrate, adjustment of surface tension of a solvent, adjustment of polarity, adjustment of boiling point and the like.

Examples of such a solvent include propylene glycol monomethyl ether, ethylene glycol monobutyl ether, diethylene glycol diethyl ether, diethylene glycol dimethyl ether, diethylene glycol monoethyl ether acetate, diethylene glycol monobutyl ether acetate, dipropylene glycol monomethyl ether, propylene glycol monomethyl ether acetate, diethylene glycol monoethyl ether, diacetone alcohol, γ-butyrolactone, ethyl lactate, n-hexyl acetate although not limited thereto. These solvent may be used singly or in admixture of at least two.

Although the viscosity of the varnish of the present invention is appropriately set depending on the thickness of a thin film to be prepared and the solid concentration, it is generally 1 to 50 mPa·s at 25°C.

Although the solid concentration of the charge-transporting varnish of the present invention is appropriately set while taking into consideration the viscosity and surface tension of the varnish and the thickness of a thin film to be prepared, it is generally within a range of approximately 0.1% to 10.0% by weight. When improvement in coating properties of the varnish is taken into account, the solid concentration is preferably approximately 0.5% to 5.0% by weight, more preferably approximately 1.0% to 3.0% by weight.

When the charge-transporting varnish set out above is coated and baked on a substrate, a charge-transporting thin film can be formed on the substrate.

The manner of coating the varnish is not specifically limited, and specific mention is made of a dipping method, a spin coating method, a transfer printing method, a roll coating method, a brushing method, an inkjet method, a spraying method and the like. It is preferred to adjust the viscosity and surface tension of a varnish depending on the manner of coating.

When using the varnish of the present invention, no specific limitation is placed on the baking atmosphere. A thin film having a uniform film-formed surface and good charge transportability can be obtained not only in the atmosphere, but also in an inert gas such as nitrogen or in vacuum.

The baking temperature is appropriately set within a range of approximately 100°C to 260°C while taking into consideration the use of the resultant thin film, the degree of charge transportability imparted to the resultant thin film, and the type and boiling point of solvent. Where the resultant thin film is used as a hole injection layer of an organic EL element, the baking temperature is preferably approximately 140°C to 250°C, more preferably approximately 145°C to 240°C.

It will be noted that the baking may be effected while changing the temperature in at least two stages so as to develop more uniform film-forming properties and cause the reaction to proceed on a substrate. Heating is carried out by using, for example, an appropriate device such as a hot plate or an oven.

The film thickness of the charge-transporting thin film is not specifically limited. When used as a hole injection layer of an organic EL element, the thickness is preferably 5 nm to 200 nm. The method of changing a film thickness includes a method wherein the solid concentration in the varnish is changed or a method wherein an amount of a solution coated on a substrate is changed.

The materials used for making an organic light-emitting diode (OLED) element using the charge-transporting varnish of the present invention, and the fabrication method include those set forth below although not limited thereto.

An electrode substrate used is preferably cleaned by subjecting to preliminary liquid washing with a detergent, an alcohol, or pure water. For instance, with an anode substrate, it is preferred to subject to a surface treatment, such as an ultraviolet (UV) ozone treatment or oxygen-plasma treatment just prior to its use. In this regard, however, where the anode material is made mainly of an organic material, the surface treatment may not be carried out.

A method of making an OLED element having a hole injection layer, which is formed of the thin film obtained from the charge-transporting varnish of the present invention, is set out below.

A charge-transporting varnish of the present invention is coated and baked onto an anode substrate according to the above method to form a hole injection layer on the electrode. This is introduced into a vacuum deposition apparatus, followed by successive deposition of a hole transporting layer, a light emission layer, an electron transporting layer/hole blocking layer, and a cathode metal. It will be noted that an electron blocking layer may be provided between the light emission layer and the hole transporting layer, if necessary.

The anode materials include transparent electrodes, typical of which is indium tin oxide (ITO) or indium zinc oxide (IZO), and metal anodes constituted of metals, typically such as aluminum and alloys thereof. Those subjected to planarization treatment are preferred. Additionally, polythiophene derivatives and polyaniline derivatives having high charge transportability may also be used.

Other metals constituted of the metal anode include scandium, titanium, vanadium, chromium, manganese, iron, cobalt, nickel, copper, zinc, gallium, yttrium, zirconium, niobium, molybdenum, ruthenium, rhodium, palladium, cadmium, indium, scandium, lanthanum, cerium, praseodymium, neodymium, promethium, samarium, europium, gadolinium, terbium, dysprosium, holmium, erbium, thulium, ytterbium, hafnium, thallium, tungsten, rhenium, osmium, iridium, platinum, gold, titanium, lead, bismuth, and alloys thereof although not limited thereto.

The materials for forming the hole transporting layer include: triarylamines such as
(triphenylamine) dimer derivatives,
[(triphenylamine) dimer]spiro dimer,
N,N'-bis(naphthalen-1-yl)-N,N'-bis(phenyl)-benzidine (α-NPD),
N,N'-bis(naphthalen-2-yl)-N,N'-bis(phenyl)-benzidine,
N,N'-bis(3-methylphenyl)-N,N'-bis(phenyl)-benzidine,
N,N'-bis(3-methylphenyl)-N,N'-bis(phenyl)-9,9-spirobifluorene,
N,N'-bis(naphthalen-1-yl)-N,N'-bis(phenyl)-9,9-spirobifluorene,
N,N'-bis(3-methylphenyl)-N,N'-bis(phenyl)-9,9-dimethyl-fluorene,
N,N'-bis(naphthalen-1-yl)-N,N'-bis(phenyl)-9,9-dimethyl-fluorene,
N,N'-bis(3-methylphenyl)-N,N'-bis(phenyl)-9,9-diphenyl-fluorene,
N,N'-bis(naphthalen-1-yl)-N,N'-bis(phenyl)-9,9-diphenyl-fluorene,
N,N'-bis(naphthalen-1-yl)-N,N'-bis(phenyl)-2,2'-dimethylbenzidine,
2,2',7,7'-tetrakis(N,N-diphenylamino)-9,9-spirobifluorene,
9,9-bis[4-(N,N-bis-biphenyl-4-yl-amino)phenyl]-9H-fluorene,
9,9-bis[4-(N,N-bis-naphthalen-2-yl-amino)phenyl]-9H-fluorene,
9,9-bis[4-(N-naphthalen-1-yl-N-phenylamino)-phenyl]-9H-fluorene,
2,2',7,7'-tetrakis[N-naphthalenyl(phenyl)-amino]-9,9-spirobifluorene,
N,N'-bis(phenanthren-9-yl)-N,N'-bis(phenyl)-benzidine,
2,2'-bis[N,N-bis(biphenyl-4-yl)amino]-9,9-spirobifluorene,
2,2'-bis(N,N-biphenylamino)-9,9-spirobifluorene, di-[4-(N,N-di(p-tolyl)amino)-phenyl]cyclohexane,
2,2',7,7'-tetra(N,N-di(p-tolyl))amino-9,9-spirobifluorene,
N,N,N',N'-tetra-naphthalen-2-yl-benzidine,
N,N,N',N'-tetra-(3-methylphenyl)-3,3'-dimethylbenzidine,
N,N'-di(naphthalenyl)-N,N'-di(naphthalen-2-yl)-benzidine,
N,N,N',N'-tetra(naphthalenyl)-benzidine,
N,N'-di(naphthalen-2-yl)-N,N'-diphenylbenzidine-1,4-diamine,
N¹,N⁴-diphenyl-N¹,N⁴-di (m-tolyl) benzene-1,4-diamine,
N²,N²,N⁶,N⁶-tetraphenylnaphthalene-2, 6-diamine,
tris(4-(quinolin-8-yl)phenyl)amine,
2,2'-bis(3-(N,N-di(p-tolyl)amino)phenyl)biphenyl,
4,4',4"-tris[3-methylphenyl(phenyl)amino]triphenylamine (m-MTDATA), and
4,4',4"-tris[1-naphthyl(phenyl)amino]triphenylamine (1-TNATA); and oligothiophenes such as
5,5"-bis-{4-[bis(4-methylphenyl)amino]phenyl}-2,2':5',2"-terthiophene (BMA-3T).

The materials for forming the light emission layer include
tri(8-quinolinolato)aluminum(III) (Alq₃),
bis(8-quinolinolato)zinc (II) (Znq₂),
bis(2-methyl-8-quinolinolato)(p-phenylphenolato)aluminum (III) (BAlq),
4,4'-bis(2,2-diphenylvinyl)biphenyl,
9,10-di(naphthalen-2-yl)anthracene,
2-t-butyl-9,10-di(naphthalen-2-yl)anthracene,
2,7-bis[9,9-di(4-methylphenyl)-fluoren-2-yl]-9,9-di(4-methylphenyl)fluorene,
2-methyl-9,10-bis(naphthalen-2-yl)anthracene,
2-(9,9-spirobifluorene-2-yl)-9,9-spirobifluorene,
2,7-bis(9,9-spirobifluorene-2-yl)-9,9-spirobifluorene,
2-[9,9-di(4-methylphenyl)-fluoren-2-yl]-9,9-di(4-methylphenyl)fluorene,
2,2'-dipyrenyl-9,9-spirobifluorene,
1,3,5-tris(pyren-1-yl)benzene,
9,9-bis[4-(pyrenyl)phenyl]-9H-fluorene,
2,2'-bi(9,10-diphenylanthracene),
2,7-dipyrenyl-9,9-spirobifluorene,
1,4-di(pyren-1-yl)benzene, 1,3-di(pyren-1-yl)benzene,
6,13-di(biphenyl-4-yl)pentacene,
3,9-di(naphthalen-2-yl)perylene,
3,10-di(naphthalen-2-yl)perylene,
tris[4-(pyrenyl)-phenyl]amine,
10,10'-di(biphenyl-4-yl)-9,9'-bianthracene,
N,N'-di(naphthalen-1-yl)-N,N'-diphenyl-[1,1':4',1":4",1'"-quaterphenyl]-4,4'"-diamine,
4,4'-di[10-(naphthalen-1-yl)anthracen-9-yl]biphenyl,
dibenzo{[f,f']-4,4',7,7'-tetraphenyl}diindeno[1,2,3-cd:1',2',3'-lm]perylene,
1-(7-(9,9'-bianthracen-10-yl)-9,9-dimethyl-9H-fluoren-2-yl)pyrene,
1-(7-(9,9'-bianthracen-10-yl)-9,9-dihexyl-9H-fluoren-2-yl)pyrene,
1,3-bis(carbazol-9-yl)benzene,

1,3,5-tris(carbazol-9-yl)benzene,
4,4',4"-tris(carbazol-9-yl)triphenylamine,
4,4'-bis(carbazol-9-yl)biphenyl (CBP),
4,4'-bis(carbazol-9-yl)-2,2'-dimethylbiphenyl,
2,7-bis(carbazol-9-yl)-9,9-dimethylfluorene,
2,2',7,7'-tetrakis(carbazol-9-yl)-9,9-spirobifluorene,
2,7-bis(carbazol-9-yl)-9,9-di(p-tolyl)fluorene,
9,9-bis[4-(carbazol-9-yl)-phenyl]fluorene,
2,7-bis(carbazol-9-yl)-9,9-spirobifluorene,
1,4-bis(triphenylsilyl)benzene,
1,3-bis(triphenylsilyl)benzene,
bis(4-N,N-diethylamino-2-methylphenyl)-4-methylphenylmethane, 2,7-bis(carbazol-9-yl)-9,9-dioctylfluorene,
4,4"-di(triphenylsilyl)-p-terphenyl,
4,4'-di(triphenylsilyl)biphenyl,
9-(4-t-butylphenyl)-3,6-bis(triphenylsilyl)-9H-carbazole, 9-(4-t-butylphenyl)-3,6-ditrityl-9H-carbazole,
9-(4-t-butylphenyl)-3,6-bis(9-(4-methoxyphenyl)-9H-fluoren-9-yl)-9H-carbazole,
2,6-bis(3-(9H-carbazol-9-yl)phenyl)pyridine,
triphenyl(4-(9-phenyl-9H-fluoren-9-yl)phenyl)silane,
9,9-dimethyl-N,N-diphenyl-7-(4-(1-phenyl-1H-benzo[d]imidazol-2-yl)phenyl)-9H-fluorene-2-amine,
3,5-bis(3-(9H-carbazol-9-yl)phenyl)pyridine,
9,9-spirobifluorene-2-yl-diphenyl-phosphine oxide,
9,9'-(5-(triphenylsilyl)-1,3-phenylene)bis(9H-carbazole), 3-(2,7-bis(diphenylphosphoryl)-9-phenyl-9H-fluoren-9-yl)-9-phenyl-9H-carbazole,
4,4,8,8,12,12-hexa(p-tolyl)-4H-8H-12H-12C-azabenzo[cd,mn]-pyrene,
4,7-di(9H-carbazol-9-yl)-1,10-phenanthroline,
2,2'-bis(4-(carbazol-9-yl)phenyl)biphenyl,
2,8-bis(diphenylphosphoryl)dibenzo[b,d]thiophene,
bis(2-methylphenyl)diphenylsilane,
bis[3,5-di(9H-carbazol-9-yl)phenyl]diphenylsilane, 3,6-bis(carbazol-9-yl)-9-(2-ethyl-hexyl)-9H-carbazole,
3-(diphenylphosphoryl)-9-(4-(diphenylphosphoryl)phenyl)-9H-carbazole, and
3,6-bis[(3,5-diphenyl)phenyl]-9-phenylcarbazole. This material may be co-evaporated with a light-emitting dopant to form a light emission layer.

The light-emitting dopants include
3-(2-benzothiazolyl)-7-(diethylamino)coumalin,
2,3,6,7-tetrahydro-1,1,7,7-tetramethyl-1H,5H,11H-10-(2-benzothiazolyl)quinolizino[9,9a,1gh]coumalin,
quinacridone, N,N'-dimethyl-quinacridone,
tris(2-phenylpyridine)iridium(III) (Ir(ppy)₃),
bis(2-phenylpyridine)(acetylacetonate)iridium(III) (Ir(ppy)₂(acac)),
tris[2-(p-tolyl)pyridine]iridium(III) (Ir(mppy)₃),
9,10-bis[N,N-di(p-tolyl)amino]anthracene,
9,10-bis[phenyl(m-tolyl)amino]anthracene,
bis[2-(2-hydroxyphenyl)benzothiazorato]zinc(II),
N¹⁰,N¹⁰,N^{10'},N^{10'}-tetra(p-tolyl) -9, 9' -bianthracene-10, 10' -diamine,
N¹⁰,N¹⁰,N^{10'},N^{10'}-tetraphenyl-9,9' -bianthracene-10, 10' -diamine,
N¹⁰,N¹⁰,-diphenyl-N¹⁰,N^{10'}-dinaphthalenyl-9,9' -bianthracene-10,10'-diamine,
4,4'-bis(9-ethyl-3-carbazovinylene)-1,1'-biphenyl, perylene, 2,5,8,11-tetra-t-butylperylene,
1,4-bis[2-(3-N-ethylcarbazolyl)vinyl]benzene,
4,4'-bis[4-(di-p-tolylamino)styryl]biphenyl,
4-(di-p-tolylamino)-4'-[(di-p-tolylamino)styryl]stilbene,
bis[3,5-difluoro-2-(2-pyridyl)phenyl-(2-carboxypyridyl)]-iridium(III),
4,4'-bis[4-(diphenylamino)styryl]biphenyl,
bis(2,4-difluorophenylpyridinato)tetrakis(1-pyrazolyl)borate iridium(III),
N,N'-bis(naphthalen-2-yl)-N,N'-bis(phenyl)-tris(9,9-dimethylfluorenylene),
2,7-bis{2-[phenyl(m-tolyl)amino]-9,9-dimethyl-fluoren-7-yl}-9,9-dimethyl-fluorene,
N-(4-((E)-2-(6((E)-4-(diphenylamino)styryl)naphthalen-2-yl)vinyl)phenyl)-N-phenylbenzeneamine,
fac-iridium(III) tris(1-phenyl-3-methylbenzimidazolin-2-ylidene-C,C^{2'}),
mer-iridium(III) tris(1-phenyl-3-methylbenzimidazolin-2-ylidene-C,C^{2'}),
2,7-bis[4-(diphenylamino)styryl]-9,9-spirobifluorene,
6-methyl-2-(4-(9-(4-(6-methylbenzo[d]thiazol-2-yl)phenyl)-anthracen-10-yl)phenyl)benzo[d]thiazole,
1,4-di[4-(N,N-diphenyl)amino]styrylbenzene,
1,4-bis(4-(9H-carbazol-9-yl)styryl)benzene,
(E)-6-(4-(diphenylamino)styryl)-N,N-diphenylnapthalene-2-amine,
bis(2,4-difluorophenylpyridinato)(5-(pyridin-2-yl)-1H-tetrazolate)iridium(III),
bis(3-trifluromethyl-5-(2-pyridyl)pyrazole)((2,4-difluoro-benzyl)diphenylphosphinate)iridium(III),
bis(3-trifluoromethyl-5-(2-pyridyl)pyrazolate)(benzyl-diphenylphosphinate) iridium(III),
(bis(1-(2,4-difluorobenzyl)-3-methylbenzimidazolium)(3-(trifluoromethyl)-5-(2-pyridyl)-1,2,4-triazolate)iridium(III),
bis(3-trifluoromethyl-5-(2-pyridyl)pyrazolate)(4',6'-difluorophenylpyridinate) iridium (III),
bis(4',6'-difluorophenylpyridinato)(3,5-bis(trifluoromethyl)-2-(2'-pyridyl)pyrolate)iridium(III),
bis(4',6'-difluorophenylpyridinato)(3-(trifluoromethyl)-5-(2-pyridyl)-1,2,4-triazolate)iridium(III),
(Z)-6-mesityl-N-(6-mesitylquinolin-2(1H)-ylidene)quinoline-2-amine-BF₂,
(E)-2-(2-(4-(dimethylamino)styryl)-6-methyl-4H-pyran-4-ylidene)malononitrile,
4-(dicyanomethylene)-2-methyl-6-julolidyl-9-enyl-4H-pyrane,
4-(dicyanomethylene)-2-methyl-6-(1,1,7,7-tetramethyl-julolidyl-9-enyl)-4H-pyrane,
4-(dicyanomethylene)-2-t-butyl-6-(1,1,7,7-tetramethyl-julolidin-4-yl-vinyl)-4H-pyrane,
tris(dibenzoylmethane)phenanthroline europium(III), 5,6,11,12-tetraphenylnaphthacene,
bis(2-benzo[b]thiophen-2-yl-pyridine)(acetylacetonate)-iridium(III),
tris(1-phenylisoquinoline)iridium(III), bis(1-phenylisoquinoline)(acetylacetonate)iridium(III),
bis[1-(9,9-dimethyl-9H-fluoren-2-yl)-isoquinoline](acetylacetonate)iridium (III),
bis[2-(9,9-dimethyl-9H-fluoren-2-yl)quinoline](acetylacetonate)iridium (III),
tris[4,4'-di-t-butyl-(2,2')-bipyridine]-ruthenium(III)·bis(hexafluorophosphate),
tris(2-phenylquinoline)iridium(III), bis(2-phenylquinoline)(acetylacetonate)iridium(III),
2,8-di-t-butyl-5,11-bis(4-t-butylphenyl)-6,12-diphenyltetracene,
bis(2-phenylbenzothiazorato)(acetylacetonate)iridium(III), 5,10,15,20-tetraphenyltetrabenzoporphyrin platinum,
osmium(II) bis(3-trifluoromethyl-5-(2-pyridine)-pyrazolate)dimethylphenylphopshine,
osmium(II) bis(3-(trifluoromethyl)-5-(4-t-butylpyridyl)-1,2,4-triazolate)diphenylmethylphosphine,
osmium(II) bis(3-(trifluoromethyl)-5-(2-pyridyl)-1,2,4-triazole)dimethylphenylphosphine,
osmium(II) bis(3-(trifluoromethyl)-5-(4-t-butylpyridyl)-1,2,4-triazolate)dimethylphenylphosphine,

bis[2-(4-n-hexylphenyl)quinoline](acetylacetonate)iridium(III), tris[2-(4-n-hexylphenyl)quinoline]iridium(III),
tris[2-phenyl-4-methylquinoline]iridium(III),
bis(2-phenylquinoline)(2-(3-(methylphenyl)pyridinate)-iridium(III),
bis(2-(9,9-diethyl-fluoren-2-yl)-1-phenyl-1H-benzo[d]-imidazolato)(acetylacetonate)iridium(III),
bis(2-phenylpyridine)(3-(pyridin-2-yl)-2H-chromen-2-onate)-iridium(III),
bis(2phenylquinoline)(2,2,6,6-tetramethylheptan-3,5-dionate)-iridium(III),
bis(phenylisoquinoline)(2,2,6,6-tetramethylheptan-3,5-dionate)iridium(III),
iridium(III) bis(4-phenylthieno[3,2-c]pyridinato-N,C^{2'})-acetylacetonate,
(E)-2-(2-t-butyl-6-(2-(2,6,6-trimethyl-2,4,5,6-tetrahydro-1H-pyrrolo[3,2,1-ij]quinolin-8-yl)vinyl)-4H-pyran-4-ylidene)-malononitrile,
bis(3-trifluoromethyl-5-(1-isoquinolyl)pyrazolate)(methyldiphenylphosphine)ruthenium,
bis[(4-n-hexylphenyl)isoquinoline](acetylacetonate)-iridium(III),
platinum(II) octaethylporphine,
bis(2-methyldibenzo[f,h]quinoxaline)(acetylacetonate)-iridium(III), and
tris[(4-n-hexylphenyl)quinoxaline]iridium(III).

The materials for forming the electron transporting layer/hole blocking layer include
8-hydroxyquinolate-lithium,
2,2',2"-(1,3,5-benzinetolyl)-tris(1-phenyl-1-H-benzimidazole), 2-(4-biphenyl)5-(4-t-butylphenyl)-1,3,4-oxadiazole,
2,9-dimethyl-4,7-diphenyl-1,10-phenanthroline,
4,7-diphenyl-1,10-phenanthroline,
bis(2-methyl-8-quinolinolate)-4-(phenylphenolato)aluminum, 1,3-bis[2-(2,2'-bipyridin-6-yl)-1,3,4-oxadiazo-5-yl]benzene, 6,6'-bis[5-(biphenyl-4-yl)-1,3,4-oxadiazo-2-yl]-2,2'-bipyridine,
3-(4-biphenyl)-4-phenyl-5-t-butylphenyl-1,2,4-triazole, 4-(naphthalen-1-yl)-3,5-diphenyl-4H-1,2,4-triazole, 2,9-bis(naphthalen-2-yl)-4,7-diphenyl-1,10-phenanthroline, 2,7-bis[2-(2,2'-bipyridin-6-yl)-1,3,4-oxadiazo-5-yl]-9,9-dimethylfluorene,
1,3-bis[2-(4-t-butylphenyl)-1,3,4-oxadiazo-5-yl]benzene, tris(2,4,6-trimethyl-3-(pyridin-3-yl)phenyl)borane, 1-methyl-2-(4-(naphthalen-2-yl)phenyl)-1H-imidazo-[4,5f][1,10]phenanthroline,
2-(naphthalen-2-yl)-4,7-diphenyl-1,10-phenanthroline, phenyl-dipyrenylphosphine oxide,
3,3',5,5'-tetra[(m-pyridyl)-phen-3-yl]biphenyl,
1,3,5-tris[(3-pyridyl)-phen-3-yl]benzene,
4,4'-bis(4,6-diphenyl-1,3,5-triazin-2-yl)biphenyl, 1,3-bis[3,5-di(pyridin-3-yl)phenyl]benzene,
bis(10-hydroxybenzo[h]quinolinato)beryllium, diphenyl bis[4-(pyridin-3-yl)phenyl]silane, and 3,5-di(pyren-1-yl)pyridine.

The materials for forming the electron injection layer include lithium oxide (Li₂O), magnesium oxide (MgO), alumina (Al₂O₃), lithium fluoride (LiF), sodium fluoride (NaF), magnesium fluoride (MgF₂), cesium fluoride (CsF), strontium fluoride (SrF₂), molybdenum trioxide (MoO₃), aluminum, Li(acac), lithium acetate, and lithium benzoate.

The cathode materials include aluminum, magnesium-silver alloys, aluminum-lithium alloys, lithium, sodium, potassium, and cesium.

The materials for forming the electron blocking layer include tris(phenylpyrazole)iridium.

Although a method of forming a polymer light-emitting diode (PLED) element using a charge-transporting varnish of the present invention is not specifically limited, the following method can be mentioned.

In the above fabrication of the OLED element, a PLED element having a charge-transporting thin film formed of a charge-transporting varnish of the present invention can be fabricated by successively forming a hole transporting polymer layer and a light emission polymer layer in place of the vacuum deposition operations of the hole transporting layer, light emission layer, electron transporting layer, and electron injection layer.

More particularly, the charge-transporting varnish of the present invention is coated onto an anode substrate according to the method described hereinbefore to provide a hole injection layer, on which a charge transporting polymer layer and a light-emitting polymer layer are successively formed, followed by vacuum deposition of an anode to provide a PLED element.

The cathode and anode materials used are similar ones as used in the fabrication of the above OLED element, and similar washing treatment and surface treatment may be carried out.

The method of forming the hole transporting polymer layer and the light-emitting polymer layer includes one wherein a hole transporting polymer material or a light-emitting polymer material, or a material obtained by adding a dopant substance to either of the above polymer materials is dissolved or uniformly dispersed in a solvent, followed by coating onto a hole injection layer or hole transporting polymer layer and baking for film formation.

The hole transporting polymer materials include poly[(9,9-dihexylfluorenyl-2,7-diyl)-co-(N,N'-bis{p-butylphenyl}-1,4-diaminophenylene)], poly[(9,9-dioctylfluorenyl-2,7-diyl)-co-(N,N'-bis{p-butylphenyl}-1,1'-biphenylene-4,4-diamine)], poly[(9,9-bis{1'-penten-5'-yl}fluorenyl-2,7-diyl)-co-(N,N'-bis{p-butylphenyl}-1,4-diaminophenylene)], poly[N,N'-bis(4-butylphenyl)-N,N'-bis(phenyl)benzidine]-end capped with polysilsesquinoxane, and poly[(9,9-dioctylfluorenyl-2,7-diyl)-co-(4,4'-(N-(p-butylphenyl))diphenylamine)].

The light-emitting polymer materials include polyflurorene derivatives such as poly(9,9-dialkylfluorene) (PDAF), polyphenylenevinylene derivatives such as poly(2-methoxy-5-(2'-ethylhexoxy)-1,4-phenylenevinylene) (MEH-PPV), polythiophene derivatives such as poly(3-alkylthiophene) (PAT), and polyvinyl carbazole (PVCz).

The solvents include toluene, xylene, and chloroform, and dissolution or uniform dispersion is carried out by agitation, thermal agitation, or ultrasonic dispersion.

The coating method is not specifically limited and includes an inkjet method, a spraying method, a dipping method, a spin coating method, a transfer printing method, a roll coating method, or a brushing method. It will be noted that the coating is preferably effected in an inert gas such as nitrogen or argon.

The baking is carried out by a method of heating in an oven or with a hot plate in an inert gas or in vacuum.

### EXAMPLES

The present invention is more particularly described by way of Examples and Comparative Examples and should not be construed as limited to the following Examples. The apparatus or devices used are as shown below.
(1) Substrate cleaning:
   substrate cleaning apparatus (reduced pressure plasma system), manufactured by Choshu Industry Co., Ltd.
(2) Coating of varnish:
   Spin Coater MS-A100, manufactured by Mikasa Co., Ltd.
(3) Measurement of film thickness:
   Fine-shape measuring instrument Surfcoder ET-4000, manufactured by Kosaka Laboratory Ltd.
(4) Fabrication of EL element:
   Multifunctional vacuum deposition device C-E2L1G1-N, manufactured by Choshu Industry Co., Ltd.
(5) Measurement of luminance, etc., of EL element:
   I-V-L measuring system, manufactured by Tec World Inc.
(6) Measurement of the life of EL element (measurement of the half life of luminance):
   Organic EL luminance life evaluation system PEL-105S, manufactured by EHC K.K.

### [1] Preparation of charge-transporting varnish

### [Example 1-1]

0.211 g of N,N'-di(1-naphthyl)benzidine and 0.218 g of an arylsulfonic acid represented by the formula (A1) were dissolved in 15 g of 1,3-dimethyl-2-imidazolidinone (hereinafter referred to as DMI) in an atmosphere of nitrogen. 3.0 g of cyclohexanol (hereinafter referred to as CHA) and 3.0 g of propylene glycol (hereinafter referred to as PG) were further added to the resulting solution and agitated to prepare a charge-transporting varnish.

It will be noted that the arylsulfonic acid represented by the formula (A1) was synthesized based on the description of WO 2006/025342 (the same hereinafter).

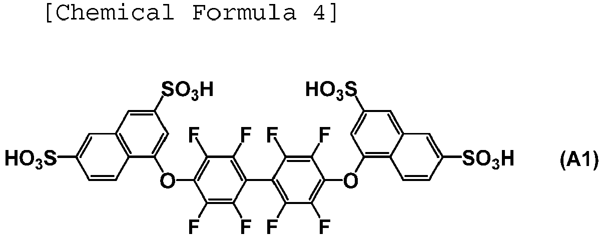

### [Example 1-2]

0.143 g of N,N'-di(l-naphthyl)benzidine, 0.200 g of an arylsulfonic acid represented by the above formula (A1), and 0.086 g of phosphotungstic acid were dissolved in 15 g of DMI in an atmosphere of nitrogen. 3.0 g of CHA and 3.0 g of PG were further added to the resulting solution and agitated to prepare a charge-transporting varnish.

### [Comparative Example 1]

A charge-transporting varnish was prepared in similar manner as in Example 1-2 except that N,N'-diphenylbenzidine was used instead of N,N'-di(1-naphthyl)benzidine.

### [2] Fabrication of organic EL element and characteristic evaluation

### [Example 2-1]

The charge-transporting varnish obtained in Example 1-1 was coated onto an ITO substrate by use of the spin coater and dried at 80°C for one minute, followed by baking in the atmosphere at 230°C for 15 minutes to form a 30 nm thick, uniform thin film on the ITO substrate. The ITO substrate used was a 25 mm × 25 mm × 0.7 t glass substrate wherein indium tin oxide (ITO) was patterned on the surface of the substrate in a film thickness of 150 nm, and impurities on the surface were removed prior to its use by means of the O₂ plasma cleaning device (150 W, 30 seconds).

Next, thin films of N,N'-di(l-naphthyl)-N,N'-diphenylbenzidine (α-NPD), tris(8-quinolinolato)aluminum(III) (Alq₃), lithium fluoride, and aluminum were successively stacked on the ITO substrate having formed with the thin film by use of a vacuum deposition apparatus (a degree of vacuum: 1.0×10⁻⁵ Pa) to obtain an organic EL element. The vacuum deposition was carried out at a deposition rate of 0.2 nm/second for α-NPD, Alq₃, and aluminum and 0.02 nm/second for lithium fluoride, respectively, and the film thicknesses were, respectively 30 nm, 40 nm, 0.5 nm, and 100 nm.

It will be noted that the organic EL element was sealed with sealing substrates so as to prevent characteristic degradation as would be caused by the influence of oxygen, and moisture in air, followed by evaluation of its characteristics. The sealing was carried out according to the following procedure.

The organic EL element was placed between sealing substrates in an atmosphere of nitrogen having an oxygen concentration of up to 2 ppm and a dew point of up to -85°C, and the sealing substrates were bonded together with an adhesive material (Moresco Moisture Cut WB90US(P), manufactured by Moresco Corporation). On this occasion, a water collecting agent (HD-071010W-40, manufactured by Dynic Corporation) was accommodated in the sealing substrates along with the organic EL element. UV light (wavelength: 365 nm, irradiation: 6,000 mJ/cm²) was irradiated against the bonded sealing substrates, followed by annealing at 80°C for one hour to cure the adhesive material.

### [Examples 2-2 and Comparative Example 2]

Organic EL elements were made in similar manner as in Example 2-1 except that the varnishes of Example 1-2 and Comparative Example 1 were individually used in place of the varnish obtained in Example 1-1.

The elements made in the above Examples 2-1 and 2-2 were subjected to measurement of current density, luminance and current efficiency at a drive voltage of 5 V. The results are shown in Table 1.

Moreover, the elements made in Examples 2-1 and 2-2 and Comparative Example 2 were subjected to measurement of a half life of luminance (initial luminance 5000 cd/m²). The results are shown in Table 2.

**[Table 1]**

| | Current density (mA/cm²) | Luminance (cd/m²) | Current efficiency (cd/A) |
|---|---|---|---|
| Example 2-1 | 78.0 | 2,390 | 3.1 |
| Example 2-2 | 85.7 | 2,487 | 2.9 |

**[Table 2]**

| | Half life (hours) |
|---|---|
| Example 2-1 | 319 |
| Example 2-2 | 288 |
| Comparative Example 2 | 208 |

As shown in Tables 1 and 2, it will be seen that when the thin films obtained from the charge-transporting varnishes of the present invention are used as a hole injection layer, there can be obtained the organic EL elements excellent in luminance and durability.

## Claims

1. A charge-transporting varnish comprising a charge-transporting substance, a dopant substance, and an organic solvent,
wherein the charge-transporting substance contains at least one selected from N,N'-di(l-naphthyl)benzidine, N,N'-di(2-naphthyl)benzidine, and N-(1-naphthyl)-N'-(2-naphthyl)benzidine.

2. The charge-transporting varnish of claim 1, wherein the dopant substance contains an arylsulfonic acid compound as an essential component.

3. The charge-transporting varnish of claim 1 or 2, wherein the charge-transporting varnish contains N,N'-di(l-naphthyl)benzidine.

4. The charge-transporting varnish of claim 2 or 3, wherein the dopant substance further comprises a heteropoly acid.

5. A charge-transporting thin film prepared from the charge-transporting varnish of any one of claims 1 to 4.

6. An organic electroluminescent element comprising the charge-transporting thin film of claim 5.

7. The organic electroluminescent element of claim 6, wherein the charge-transporting thin film serves as a hole injection layer.

8. A method for fabricating a charge-transporting thin film comprising coating the charge-transporting varnish of any one of claims 1 to 4 and evaporating the solvent.

9. A method for improving luminance durability of an organic electroluminescent element having an anode and a cathode, and a plurality of functional layers interposed between the anode and the cathode and including a light emission layer, a hole injection layer, and a hole transporting layer, the method including
using at least one selected from N,N'-di(l-naphthyl)benzidine, N,N'-di(2-naphthyl)benzidine, and N-(1-naphthyl)-N'-(2-naphthyl)benzidine as a charge-transporting substance for the hole injection layer.
